Europäisches Patentamt

European Patent Office

Office européen des brevets

(11) Veröffentlichungsnummer: **0 438 700 A1**

(19)

## EUROPÄISCHE PATENTANMELDUNG

(12)

(21) Anmeldenummer: 90123915.2

(22) Anmeldetag: 12.12.90

(51) Int. Cl.5: **H01L 29/74**, H01L 29/747, H01L 21/225, H01L 21/332

(30) Priorität: 25.01.90 CH 217/90

(43) Veröffentlichungstag der Anmeldung:
31.07.91 Patentblatt 91/31

(84) Benannte Vertragsstaaten:
CH DE GB LI SE

(71) Anmelder: **ASEA BROWN BOVERI AG**

CH-5401 Baden(CH)

(72) Erfinder: **Bauer, Friedhelm, Dr.**
**Kehlstrasse 2**
**CH-5400 Baden(CH)**

(54) **Abschaltbares, MOS-gesteuertes Leistungshalbleiter-Bauelement sowie Verfahren zu dessen Herstellung.**

(57) Bei einem abschaltbaren, MOS-gesteuerten Leistungshalbleiter-Bauelement werden in einem Halbleitersubstrat (1) zwischen einer ersten Hauptelektrode (H1) und einer zweiten Hauptelektrode (H2) eine Mehrzahl von ersten und zweiten Einheitszellen (Z1 bzw. Z2) abwechselnd nebeneinander angeordnet und parallelgeschaltet.

Jede der ersten Einheitszellen (Z1) enthält eine Thyristorstruktur mit einer Folge alternierend dotierter Schichten, die ein randförmiges erstes Emittergebiet (5) mit einem innenliegenden, schwächer dotierten ersten Zentralgebiet (11) einschliesst.

Jede der zweiten Einheitszellen (Z2) umfasst eine Emitterschicht (9), eine Basisschicht (8) und ein auf der Seite der ersten Hauptelektrode (H1) in die Basisschicht (8) eingelassenes, zur Basisschicht (8) entgegengesetzt dotiertes Kontaktgebiet (7).

Mittels einer einzigen ersten Gateelektrode (4) kann das Bauelement über leitende Kanäle ein- und mit erhöhter Abschaltfähigkeit ausgeschaltet werden.

Fig.2

EP 0 438 700 A1

## ABSCHALTBARES, MOS-GESTEUERTES LEISTUNGSHALBLEITER-BAU-ELEMENT SOWIE VERFAHREN ZU DESSEN HERSTELLUNG

### TECHNISCHES GEBIET

Die vorliegende Erfindung bezieht sich auf das Gebiet der Leistungselektronik. Sie betrifft insbesondere ein abschaltbares, MOS-gesteuertes Leistungshalbleiter-Bauelement sowie ein Verfahren zu dessen Herstellung.

### STAND DER TECHNIK

Seit einigen Jahren ist in der Leistungselektronik zunehmend die Entwicklung von MOS-gesteuerten Bauelementen vorangetrieben worden. Eingeleitet wurde dieser Trend von den unipolaren Leistungs-MOSFETs mit DMOS-Struktur.

Der Vorteil dieser MOS-gesteuerten Bauelemente liegt hauptsächlich in der hohen Eingangsimpedanz an der Steuerelektrode begründet. Sie ermöglicht die Ansteuerung des Bauelements mit einem vergleichsweise sehr geringen Aufwand an Leistung.

Die DMOSFETs haben jedoch einen gewichtigen Nachteil: Hohe Durchbruchspannungen müssen bei diesen Bauelementen wegen des unipolaren Leitungscharakters mit hohen Durch-lasswiderständen erkauft werden, welche die maximale Stromstärke begrenzen.

Seit kurzer Zeit ist für dieses Problem mit dem IGBT (Insulated Gate Bipolar Transistor) eine Lösung verfügbar (siehe dazu: B.J. Baliga et al., IEEE Trans. Electron Devices, ED-31, S. 821-828 (1984)-).

Der IGBT verfügt über eine Kathodenstruktur, die der des DMOSFET weitgehend ähnelt. Er kann vereinfacht als eine Kaskadenschaltung aus einem DMOSFET und einem Bipolar-Transistor aufgefasst werden. Infolge des bipolaren Stromtransports in der hochohmigen n-Basisschicht ist dieser Bereich leitfähigkeitsmoduliert; damit kann auch bei Bauelementen mit hoher Sperrspannung ein kleiner Wert für den Durchlasswiderstand realisiert werden.

Es ist nun weiterhin vorgeschlagen worden, das beschriebene Konzept der Steuerung von Leistungshalbleiter-Bauelementen über MOS-Gates auch bei Bauelementen der höchsten Leistungsklasse, nämlich bei Thyristoren, zu verwirklichen (siehe dazu den Artikel von V.A.K. Temple, IEEE Trans. Electron Devices, ED-33, S. 1609-1618 (1986)).

Bei einem derartigen MOS-gesteuerten Thyristor oder MCT (MOS Controlled Thyristor), der aus einer Vielzahl von nebeneinanderliegenden, parallelgeschalteten Einheitszellen besteht, wird das Abschalten über einen Kurzschluss des Emitters mit der p-Basis durch schaltbare Emittershorts erreicht. Als Schalter dienen dabei mit dem Emitter integrierte MOSFETs, die naturgemäss wahlweise als n- oder p-Kanal-MOSFETs ausgebildet sein können.

Im Hinblick auf eine einfache Schaltungstechnik ist es natürlich wünschenswert, mit Hilfe der MOS-Gates den Thyristor nicht nur aus- sondern auch einzuschalten. Dies sollte nach Möglichkeit mit einer einzigen Steuerelektrode erreichbar sein.

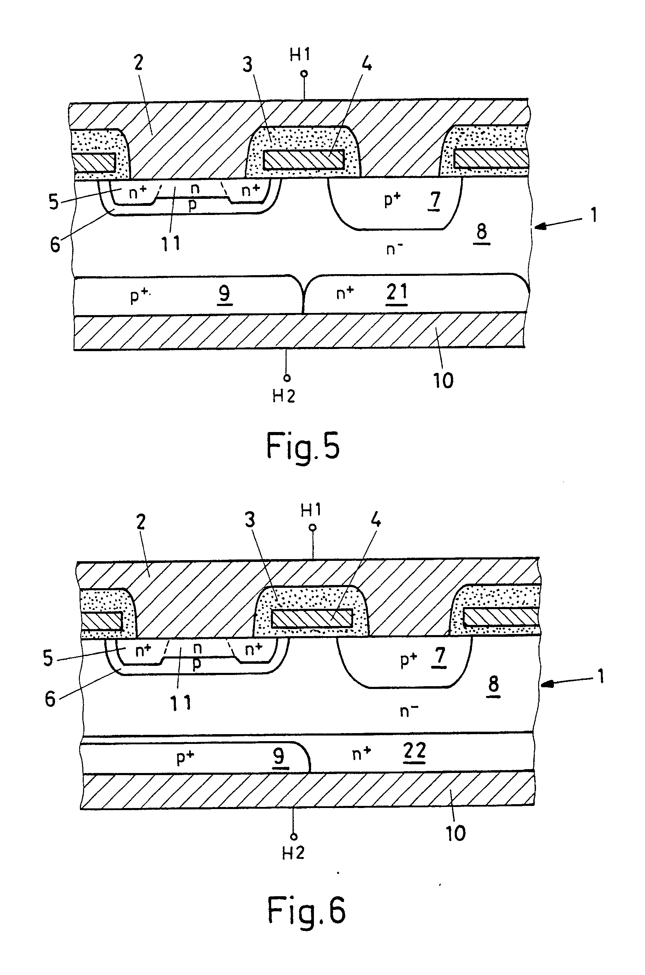

Eine Struktur, welche diese Anforderungen erfüllt, ist in dem genannten Artikel von V.A.K. Temple bereits vorgeschlagen worden (dortige Fig. 5). Es handelt sich dabei um eine kombinierte Ein- und Ausschaltzelle, bei der innerhalb der ursprünglichen MCT-Einheitszelle eine weitere DMOS-Struktur benutzt wird, um über einen Kanal in der zur Substratoberfläche hochgezogenen p-Basisschicht Elektronen in die n-Basisschicht zu injizieren.

Diese bekannte kombinierte Ein- und Ausschaltzelle wirft jedoch zwei Probleme auf:

Der Kanal des zum Einschalten verwendeten DMOSFET wird von der an die Oberfläche gezogenen p-Basisschicht gebildet. Für typische Thyristoren bewegt sich die Tiefe dieser p-Basisschicht im Bereich von wenigstens 20 Mikrometern. Dieses Mass entspricht dann auch in etwa der Kanallänge des DMOSFET. Es ist damit erheblich grösser als die typischen Kanallängen von IGBTs, welche bei ungefähr 1 Mikrometer liegen. Wegen der grossen Kanallänge werden weniger Elektronen in die n-Basisschicht injiziert, wodurch beim Einschalten der effiziente Aufbau eines Plasmas behindert und die Einschaltzeit verlängert wird.

Andererseits hat die Verwendung von kombinierten Ein- und Ausschaltzellen zur Folge, dass höchstens genausoviele Einschalt- wie Ausschaltelemente im Bauelement vorhanden sind. Es fehlt daher die Möglichkeit, Anzahl und Verteilung dieser Elemente unabhängig voneinander im Hinblick auf die an das Bauelement gestellten Anforderungen zu optimieren.

Um diesen Problemen abzuhelfen, ist in der Druckschrift EP-A1-0 340 445 vorgeschlagen worden, bei einem MCT die bekannten kombinierten Ein- und Ausschaltzellen durch zwei getrennte, parallelgeschaltete MCT- und IGBT-Einheitszellen zu ersetzen.

Für die Herstellung eines solchen Bauelements ist allerdings ein Prozess mit wenigstens 13 Maskenebenen erforderlich. Darüberhinaus ist es notwendig, eine Lithographie zu verwenden, die mit einer Genauigkeit von besser 0,2 $\mu$m arbeitet. Alle diese Bedingungen führen zu einer komplexen Produktion mit hohen Produktionskosten und einer vergleichsweise geringen Ausbeute an Bauelementen.

Auf der anderen Seite ist im Rahmen von Untersuchungen gefunden worden, dass speziell beim MCT die Abschaltfähigkeit A (Anodenstromdichte je Inkrement der Gatespannung) proportional zu einem geometrischen Verhältnis zwischen der Weite $W_{ch}$ des MOS-Kanals einer Emitterzelle oder eines Emitterstreifens und der Fläche $F_{em}$ des Emittergebietes dieser Anordnung ist:

$A = p(W_{ch}/F_{em})$;
(p: Proportionalitätsfaktor).

Von dieser Beobachtung ausgehend kann eine Verbesserung der Abschaltfähigkeit erreicht werden, wenn das Verhältnis $W_{ch}/F_{em}$ vergrössert wird.

Ein möglicher Weg liegt in der Miniaturisierung der Emitterzellen-Strukturen. Bei Zellenabmessungen von 15 $\mu$m für planare Strukturen ist allerdings die Grenze des derzeit technisch Machbaren (10 bis 12 $\mu$m) bald erreicht.

Darüberhinaus wird auch die Herstellung von Bauelementen mit immer kleineren Zellenstrukturen problematisch: die erhöhte Anfälligkeit kleinerer Strukturen gegenüber Fremdpartikeln ist aus der Geschichte der Integrierten Schaltungen hinlänglich bekannt.

## DARSTELLUNG DER ERFINDUNG

Aufgabe der vorliegenden Erfindung ist es nun, ein Bauelement zu schaffen, welches bis auf eine verbesserte Abschaltfähigkeit praktisch die gleichen elektrischen Eigenschaften aufweist, wie das Bauelement der genannten EP-A1-0 340 445, aber wesentlich einfacher und mit höherer Ausbeute hergestellt werden kann, sowie ein Verfahren zu dessen Herstellung anzugeben.

Die Aufgabe wird bei einem Bauelement der eingangs genannten Art dadurch gelöst, dass
(a) in einem Halbleitersubstrat zwischen einer ersten Hauptelektrode und einer zweiten Hauptelektrode eine Mehrzahl von ersten und zweiten Einheitszellen abwechselnd nebeneinander angeordnet und parallelgeschaltet sind;
(b) jede der ersten Einheitszellen eine erste Thyristorstruktur mit einer Folge alternierend dotierter Schichten enthält, welche Folge eine allen Einheitszellen gemeinsame Basisschicht und eine mit einer zweiten Hauptelektroden-Metallisierung verbundene Emitterschicht, ein auf der Seite der ersten Hauptelektrode in die Basisschicht eingelassenes erstes Basisgebiet und ein in das erste Basisgebiet eingelassenes, mit einer ersten Hauptelektroden-Metallisierung verbundenes erstes Emittergebiet umfasst;
(c) das erste Emittergebiet randförmig ein gleichsinnig, aber schwächer dotiertes erstes Zentralgebiet einschliesst;

(d) jede der zweiten Einheitszellen die Emitterschicht, die Basisschicht und ein auf der Seite der ersten Hauptelektrode in die Basisschicht eingelassenes, zur Basisschicht entgegengesetzt dotiertes Kontaktgebiet umfasst;
(e) ausserhalb des ersten Emittergebietes das erste Basisgebiet, und daran angrenzend zwischen den Einheitszellen die Basisschicht an die auf der Seite der ersten Hauptelektrode liegende Oberfläche des Halbleitersubstrats treten; und
(f) in diesem Bereich über dem Halbleitersubstrat auf der Seite der ersten Hauptelektrode eine isolierte erste Gateelektrode angeordnet ist.

Ausgangspunkt ist hierbei eine Bauelementstruktur, wie sie in der älteren Schweizer Patentanmeldung CH-2945/89-4 vom 10.08.89 beschrieben worden ist. Bei dieser Bauelementstruktur wird nun das bisher durchgehende erste Emittergebiet durch ein Emittergebiet ersetzt, welches randförmig ein gleichsinnig, aber schwächer dotiertes erstes Zentralgebiet einschliesst.

Ein solches rand- oder ringförmiges Emittergebiet, das zur Verbesserung der Abschaltfähigkeit bei einem MCT in der älteren Schweizer Patentanmeldung CH-3838/89-8 vom 24.10.89 bereits eingeführt worden ist, führt auch hier zu einer Vergrösserung des abschaltbaren Anodenstroms.

Eine bevorzugte Ausführungsform des erfindungsgemässen Bauelements zeichnet sich dadurch aus, dass
(a) anstelle der durchgehenden Emitterschicht lokalisierte zweite Emittergebiete in den ersten Einheitszellen vorgesehen sind;
(b) in den zweiten Einheitszellen ein auf der Seite der zweiten Hauptelektrode in die Basisschicht eingelassenes, zur Basisschicht entgegengesetzt dotiertes zweites Basisgebiet und ein in das zweite Basisgebiet eingelassenes, zum zweiten Basisgebiet entgegengesetzt dotiertes und mit der zweiten Hauptelektroden-Metallisierung verbundenes drittes Emittergebiet vorgesehen sind, welche zusammen mit der Basisschicht und dem Kontaktgebiet eine zur ersten Thyristorstruktur in den ersten Einheitszellen antiparallele, zweite Thyristorstruktur bilden;
(c) das dritte Emittergebiet randförmig ein gleichsinnig, aber schwächer dotiertes zweites Zentralgebiet einschliesst;
(d) ausserhalb des dritten Emittergebietes das zweite Basisgebiet, und daran angrenzend zwischen den Einheitszellen die Basisschicht an die auf der Seite der zweiten Hauptelektrode liegende Oberfläche des Halbleitersubstrats treten; und
(e) in diesem Bereich auf der Seite der zweiten Hauptelektrode über dem Halbleitersubstrat isolierte zweite Gateelektroden angeordnet sind.

Das erfindungsgemässe Verfahren ist dadurch gekennzeichnet, dass zum Einbringen der randförmigen ersten Emittergebiete

(a) bei dem Halbleitersubstrat, welches die Basisschicht, die ersten Basisgebiete, die ersten Zentralgebiete, die Kontaktgebiete und die in einer ersten Gateisolierung eingebetteten ersten Gateelektroden enthält, in die erste Gateisolierung im Bereich der ersten Zentralgebiete jeweils eine Oeffnung eingebracht wird;

(b) auf der Seite der ersten Hauptelektrode auf dem Halbleitersubstrat ganzflächig eine stark dotierte Maskenschicht abgeschieden wird;

(c) die Maskenschicht anisotrop bis auf an den Rändern der Oeffnungen stehenbleibende Maskenränder abgetragen wird; und

(d) die Dotierung der ersten Emittergebiete aus den Maskenrändern vorgenommen wird.

Weitere Ausführungsbeispiele der Erfindung ergeben sich aus den Unteransprüchen.

KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig.1    die grundlegende Bauelementstruktur aus der älteren Schweizer Patentanmeldung CH-2945/89-4;

Fig.2    ein erstes Ausführungsbeispiel für ein Bauelement nach der Erfindung mit randförmigem Emittergebiet;

Fig.3    zwei Schritte bei einem Verfahren zur Herstellung des randförmigen Emittergebietes nach der Erfindung;

Fig.4    ein zweites Ausführungsbeispiel für ein Bauelement nach der Erfindung mit bidirektionaler Leit- und Sperrfähigkeit;

Fig.5    ein drittes Ausführungsbeispiel für ein Bauelement nach der Erfindung mit integrierter Inversdiode; und

Fig.6    ein viertes Ausführungsbeispiel für ein Bauelement nach der Erfindung mit durchgehender Stoppschicht.

WEGE ZUR AUSFÜHRUNG DER ERFINDUNG

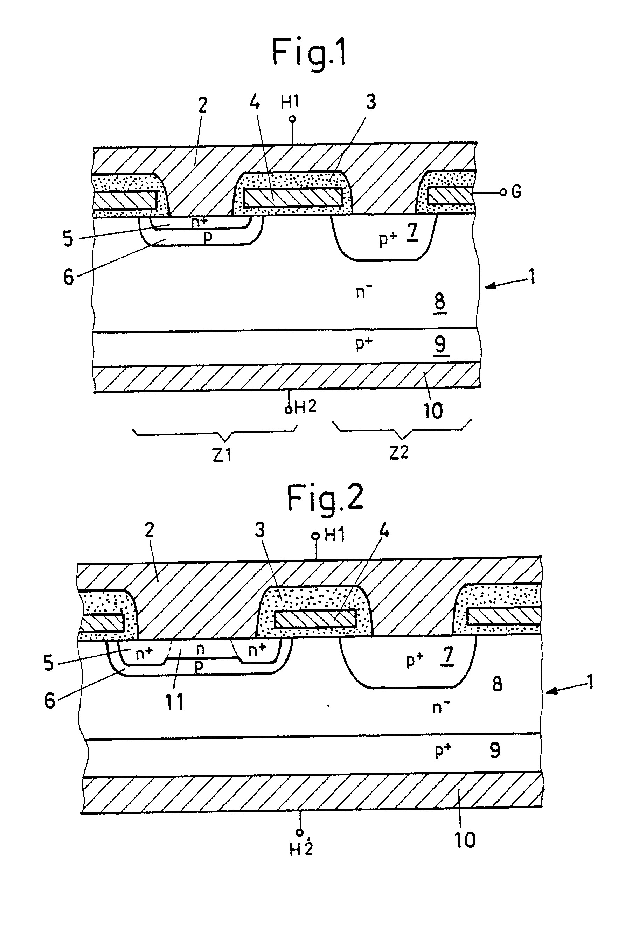

Fig.1 zeigt eine Bauelementstruktur gemäss der älteren Schweizer Patentanmeldung CH-2945/89-4. Bei dieser Struktur sind in einem Halbleitersubstrat 1 zwischen zwei Hauptelektroden H1 und H2 abwechselnd zwei Einheitszellen Z1 und Z2 nebeneinander angeordnet, die aus einer Mehrzahl unterschiedlich dotierter Schichten und Gebiete (5-9) bestehen und über eine gemeinsame erste, mit einem Gate G verbundene Gateelektrode 4 gesteuert werden.

Die erste Einheitszelle Z1 umfasst neben einer Emitterschicht 9 und einer darüberliegenden Basisschicht 8 ein auf der Seite der ersten Hauptelektrode H1 (hier: der Kathode) in die Basisschicht 8 eingelassenes erstes, pdotiertes Basisgebiet 6 und ein seinerseits in das erste Basisgebiet 6 eingelassenes, $n^+$-dotiertes, erstes Emittergebiet 5. Ausserhalb des ersten Emittergebiets 5 tritt das erste Basisgebiet 6 an die kathodenseitige Oberfläche des Halbleitersubstrats 1 und wird dort von den ersten, durch eine erste Gateisolierung 3 isolierten Gatelektroden 4 überdeckt.

Die zweite Einheitszelle Z2 umfasst neben den Schichten 8 und 9 ein kathodenseitig in die Basisschicht 8 eingelassenes, $p^+$-dotiertes Kontaktgebiet 7.

Zwischen den beiden Einheitszellen Z1 und Z2 und angrenzend an das erste Basisgebiet 6 tritt die Basisschicht 8 ebenfalls an die kathodenseitige Oberfläche des Halbleitersubstrats 1 und wird dort auch von den ersten Gate elektroden 4 überdeckt. Das erste Emittergebiet 5 und das Kontaktgebiet 7 stehen mit einer ersten Hauptelektroden-Metallisierung 2 in direkter Verbindung, die Emitterschicht 9 entsprechend mit einer zweiten Hauptelektroden-Metallisierung 10.

Die Dotierung des ersten Basisgebietes 6, welches der p-Basis eines normalen Thyristors entspricht, muss so gewählt werden, dass ein sicheres Sperren des Bauelements gewährleistet ist. Dazu darf die Raumladungszone nicht durch das erste Basisgebiet 6 bis zum ersten Emittergebiet 5 hindurchgreifen (Punch Through).

Die Dotierung muss desweiteren so gewählt werden, dass an der Oberfläche des Halbleitersubstrats 1 entlang der Peripherie der ersten Einheitszelle Z1 (im ersten Basisgebiet 6) ein n-Kanal durch Anlegen typischer Gatespannungen erzeugt werden kann.

Jede zweite Einheitszelle Z2 ist durch die niedrig dotierte Basisschicht 8 von der jeweils benachbarten ersten Einheitszelle Z2 getrennt. Mit einem entsprechenden negativen Gatepotential können die Oberflächengebiete der Basisschicht 8 zwischen den Einheitszellen invertiert werden (Bildung eines p-Kanals).

Zur Erklärung der Funktion des in Fig.1 dargestellten Bauelements sei zunächst angenommen, dass sich das Bauelement im Sperrzustand befindet. Bei einer Erhöhung der Gatespannung von 0 auf positive Werte (die über der mit dem n-Kanal im ersten Basisgebiet 6 assoziierten Schwellspannung liegen) fliessen Elektronen aus dem ersten Emittergebiet 5 durch den n-Kanal in die Basisschicht 8.

Bei entsprechender Auslegung des Diffusionsprofils für das erste Basisgebiet 6 ist die Verstärkung des zugehörigen n-p-n-Bipolartransistors hinreichend gross, sodass die Vierschichtstruktur in der ersten Einheitszelle Z1 wie bei einem Thyristor einrasten und infolge Ladungsträger-Ueberschwemmung einen sehr kleinen Widerstand einnehmen kann (im Gegensatz zu der Struktur eines typischen IGBT ist hier das Einrasten erwünscht, da so ein niederohmiger Zustand des Bauelementes erzielt werden kann.

Für das Ausschalten des Bauelementes wird an dieselbe erste Gateelektrode 4 ein negatives Potential (im Bezug auf die erste Hauptelektrode H1) angelegt; es sollte betragsmässig grösser sein als die Schwellspannung, welche mit den p-Kanälen zwischen den Einheitszellen Z1 und Z2 assoziiert ist. Unter dieser Bedingung existieren die n-Kanäle in den oberflächennahen Bereichen der ersten Basisgebiete 6 nicht mehr.

Natürlich emittieren die ersten Emittergebiete 5 der ersten Einheitszellen Z1, da die Thyristorstruktur ja eingeschaltet ist. Durch das Einschalten der p-Kanäle in der Basisschicht 8 unterhalb der ersten Gateelektroden 4 werden die ersten Basisgebiete 6 und die zweiten Einheitszellen Z2 potentialmässig gekoppelt. Diese Situation kommt der in einem IGBT sehr nahe, bei welchem das erste Basisgebiet 6 der ersten Einheitszelle Z1 und das Kontaktgebiet 7 der zweiten Einheitszelle Z2 eine Einheit bilden.

Durch die Kopplung der ersten und zweiten Einheitszellen Z1 und Z2 über einen niederohmigen p-Kanal wird das erste Basisgebiet 6 über das Kontaktgebiet 7 mit dem ersten Emittergebiet 5 praktisch kurzgeschlossen. Eine Vielzahl von Löchern können nun direkt aus den ersten Basisgebieten 6 über die p-Kanäle und die zweiten Einheitszellen Z2 abgeführt werden, ohne über das erste Emittergebiet 5 zu fliessen.

Durch das Abzapfen dieser Löcher kann die eingeschaltete Thyristorstruktur der ersten Einheitszelle Z1 ihren ON-Zustand nicht weiter aufrechterhalten: Das gesamte Bauelement geht in den Sperrzustand über.

In Fig.2 ist nun ein erstes Ausführungsbeispiel für ein Bauelement nach der Erfindung dargestellt, welches in seiner Struktur von dem in Fig.1 gezeigten Bauelement abgeleitet ist.

Während in der Fig.1 das erste Emittergebiet 5 ein kompaktes Gebiet innerhalb einer quadratischen, rechteckigen, hexagonalen oder streifenförmigen Zelle ist, weist es in Fig.2 eine ring- oder rahmenförmige Struktur auf und schliesst randförmig ein gleichsinnig, aber schwächer dotiertes (hier: n-dotiertes) erstes Zentralgebiet 11 ein. Die übrigen Elemente der Struktur sind dieselben wie in Fig.1.

Das vergleichsweise niedrig dotierte erste Zentralgebiet 11 trägt so gut wie nichts zur Emission von Elektronen bei. Die eingangs erwähnte Emitterfläche $F_{em}$ beschränkt sich damit auf das ring- oder streifenförmige erste Emittergebiet 5 und ist so drastisch reduziert. Bei sonst gleichbleibenden Abmessungen vergrössert sich das Verhältnis $W_{ch}/F_{em}$ und damit auch die Abschaltfähigkeit.

Durch die geringfügig kompliziertere Struktur des Bauelements nach Fig.2 ist auch dessen Herstellung - verglichen mit dem in Fig.1 gezeigten Konzept - etwas aufwendiger. Die Erzeugung des ring- bzw. randförmigen ersten Emittergebietes 5 (Fig.2) erfordert offensichtlich einen gewissen Mehraufwand an Prozessschritten.

Die Erzeugung des ersten Basisgebietes 6 und des Kontaktgebietes 7 mit Hilfe quasi-selbstjustierender Ionenimplantationen sind in der erwähnten älteren Schweizer Anmeldung bereits beschrieben worden.

Für die Herstellung der ersten Emittergebiete 5 kann beispielsweise wie folgt vorgegangen werden: Nach der Abscheidung der ersten Gateisolierung 3 (z.B. aus $SiO_2$ ) über den strukturierten ersten Gateelektroden 4 (z.B. aus Poly-Si) kann ein Kontaktloch zunächst nur in den ersten Einheitszellen Z1 geöffnet werden. Dann erfolgt per Implantation die selbstjustierende Erzeugung des relativ niedrig n-dotierten ersten Zentralgebietes 11.

Für die Realisierung des eigentlichen ersten Emittergebietes 5 bestehen dann zwei Möglichkeiten: Es kann einerseits in vergleichsweise konventioneller Technologie mit einer Lackmaske und entsprechender Implantation erzeugt werden. Der Platzbedarf (kleinste reproduzierbar herzustellende Lackstruktur und Justiertoleranz) ist hierbei allerdings nicht beliebig klein: Zellenabmessungen kleiner als etwa 15 bis 20 $\mu$m sind auf diese Weise kaum zu realisieren.

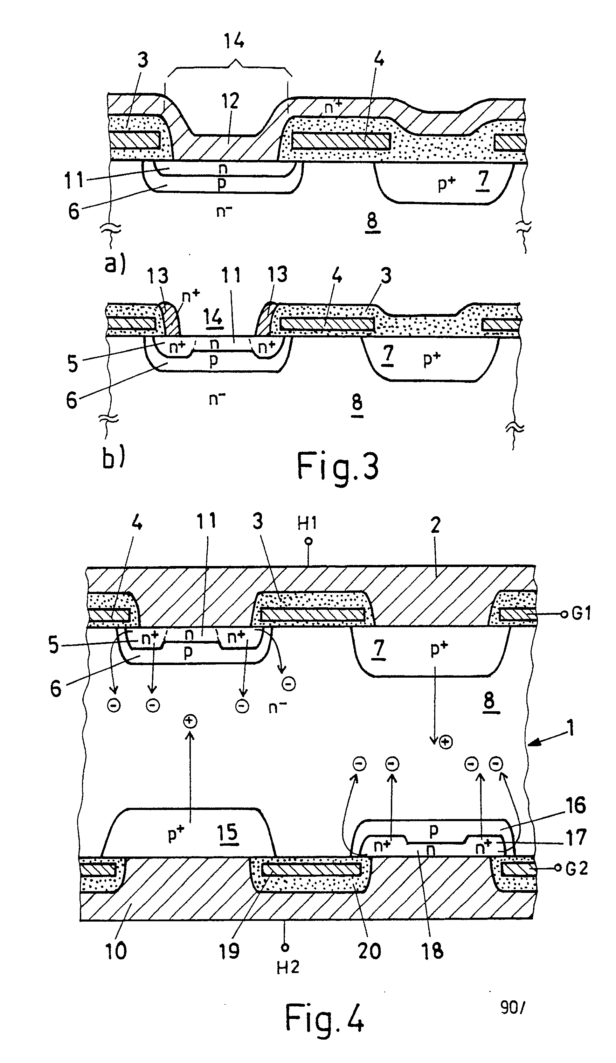

Viel einfacher lässt sich dies andererseits mit einer stark n-dotierten Maskenschicht 12 erreichen (z.B. $n^+$-Polysilizium oder ein Phosphorsilikatglas), die aus der Gasphase abgeschieden werden kann (Fig.3a). Mit Hilfe eines anisotropen Aetzprozesses ist es dann möglich, die Maskenschicht 12 derart abzutragen, dass über dem ersten Zentralgebiet 11 eine Oeffnung 14 entsteht, an den Rändern der Oeffnung 14 jedoch Maskenränder 13 stehenbleiben (Fig.3b). Aus diesen stark dotierten, räumlich sehr begrenzten Maskenrändern 13 kann dann die Dotierung der randförmigen ersten Emittergebiete 5 vorgenommen werden.

Ein zweites Ausführungsbeispiel für ein Bauelement nach der Erfindung mit bidirektionaler Leit- und Sperrfähigkeit ist in Fig.4 wiedergegeben. In diesem Fall wird ein beidseitig polierter Wafer auf beiden Seiten identisch prozessiert. Das Bauelement verfügt wiederum über zwei Hauptelektroden H1 und H2, welche je nach gerade vorliegender Stromrichtung die Rolle einer Anode/Kathode bzw. Kathode/Anode übernehmen. Naturgemäss sind hier zwei Gates G1 und G2 anzusteuern.

Erreicht wird das bidirektionale Verhalten dadurch, dass

(a) anstelle der durchgehenden Emitterschicht 9 lokalisierte zweite Emittergebiete 15 in den ersten Einheitszellen Z1 vorgesehen sind;

(b) in den zweiten Einheitszellen Z2 ein auf der Seite der zweiten Hauptelektrode H2 in die Basisschicht 8 eingelassenes, zur Basisschicht 8 entgegengesetzt dotiertes zweites Basisgebiet 16 und ein in das zweite Basisgebiet 16 eingelassenes, zum zweiten Basisgebiet 16 entgegengesetzt dotiertes und mit der zweiten Hauptelektroden-Metallisierung 10 verbundenes drittes Emittergebiet 17 vorgesehen sind, welche zusammen mit der Basisschicht 8 und dem Kontaktgebiet 7 eine zur ersten Thyristorstruktur in den ersten Einheitszellen Z1 antiparallele, zweite Thyristorstruktur bilden;

(c) das dritte Emittergebiet 17 randförmig ein gleichsinnig, aber schwächer dotiertes zweites Zentralgebiet 18 einschliesst;

(d) ausserhalb des dritten Emittergebietes 17 das zweite Basisgebiet 16, und daran angrenzend zwischen den Einheitszellen Z1, Z2 die Basisschicht 8 an die auf der Seite der zweiten Hauptelektrode H2 liegende Oberfläche des Halbleitersubstrats 1 treten; und

(e) in diesem Bereich auf der Seite der zweiten Hauptelektrode H2 über dem Halbleitersubstrat 1 isolierte zweite Gateelektroden 19 angeordnet sind.

Die unterschiedlichen Stromflüsse im Bauelement der Fig.4 sind durch Pfeile, die zugehörigen Ladungsträgersorten durch mit einem Vorzeichen versehene Kreise veranschaulicht: In der linken Hälfte ist der Stromfluss von "unten" nach "oben" angedeutet, welcher über das eine Gate G1 gesteuert wird; in der rechten Hälfte ist der Stromfluss von "oben" nach "unten" dargestellt, welcher über das andere Gate G2 gesteuert wird. Das Kontaktgebiet 7 wirkt hierbei als Emitter.

Bei den bidirektionalen Bauelementen gemäss Fig.4 kann darüberhinaus die auf der jeweiligen Anodenseite befindliche MOS-Struktur so angesteuert werden, dass sie einen MOS-gesteuerten Anodenkurzschluss bildet. Dies erlaubt eine besondere Ansteuertechnik (Aktivieren der Anodenkurzschlüsse kurz vor dem eigentlichen Abschalten der Emittergebiete 5 bzw. 17 mittels der Kathodenkurzschlüsse), welche den Abbau der Ladung innerhalb der überschwemmten Basisschicht 8 erleichtert.

Bei den bisher beschriebenene Ausführungsbeispielen waren die Basisschicht 8 n⁻-dotiert, die Emitterschicht 9 und das Kontaktgebiet 7 p⁺-dotiert, das erste Emittergebiet 5 n⁺-dotiert und das erste Basisgebiet 6 p-dotiert. Es ist jedoch auch genausogut denkbar, dort und bei den nachfolgend beschriebenen Ausführungsbeispielen Bauelemente mit einer dazu komplementären Dotierung aufzubauen.

Zwei weitere Ausführungsbeispiele für ein Bauelement nach der Erfindung sind in den Fig.5 und 6 wiedergegeben. Beide Beispiele zeichnen sich dadurch aus, dass auf der dem Kontaktgebiet 7 gegenüberliegenden Seite die Emit terschicht 9 durch ein entgegengesetzt dotiertes Gebiet unterbrochen ist, welches mit der zweiten Hauptelektroden-Metallisierung 10 verbunden ist und zusammen mit der Basisschicht 8 und dem Kontaktgebiet 7 eine integrierte Inversdiode bildet.

Die integrierte Inversdiode erspart, insbesondere beim Schalten induktiver Lasten, die Verwendung einer externen, diskreten Schutzdiode, sodass ein Schaltungsaufbau mit dem neuen Bauelement erheblich vereinfacht werden kann. Eine selbstjustierende Technik zur Herstellung der Kontaktgebiete 7 bietet hier die besten Voraussetzungen dafür, integrierte Inversdioden hoher Qualität zu erzeugen.

Im Fall der Fig.5 ist das entgegengesetzt dotierte Gebiet, welches die Emitterschicht 9 unterbricht, ein separates, n⁺-dotiertes Kurzschlussgebiet 21.

Im Fall der Fig.6 ist das entgegengesetzt dotierte Gebiet Teil einer durchgehenden (n⁺- bzw. n-dotierten) Stoppschicht 22, welche zwischen der Emitterschicht 9 und der Basisschicht 8 angeordnet ist.

**Patentansprüche**

1. Abschaltbares,          MOS-gesteuertes Leistungshalbleiter-Bauelement, dadurch gekennzeichnet, dass

(a) in einem Halbleitersubstrat (1) zwischen einer ersten Hauptelektrode (H1) und einer zweiten Hauptelektrode (H2) eine Mehrzahl von ersten und zweiten Einheitszellen (Z1 bzw. Z2) abwechselnd nebeneinander angeordnet und parallelgeschaltet sind;

(b) jede der ersten Einheitszellen (Z1) eine erste Thyristorstruktur mit einer Folge alternierend dotierter Schichten enthält, welche Folge eine allen Einheitszellen gemeinsame Basisschicht (8) und eine mit einer zweiten Hauptelektroden-Metallisierung (10) verbundene Emitterschicht (9), ein auf der Seite der ersten Hauptelektrode (H1) in die Basisschicht (8) eingelassenes erstes Basisgebiet (6) und ein in das erste Basisgebiet (6) eingelassenes, mit einer ersten Hauptelektroden-Metallisierung (2) verbundenes erstes Emittergebiet (5) umfasst;

(c) das erste Emittergebiet (5) randförmig ein gleichsinnig, aber schwächer dotiertes erstes Zentralgebiet (11) einschliesst;

(d) jede der zweiten Einheitszellen (Z2) die Emitterschicht (9), die Basisschicht (8) und ein auf der Seite der ersten Hauptelektrode (H1) in die Basisschicht (8) eingelassenes, zur Basisschicht (8) entgegengesetzt dotiertes Kontaktgebiet (7) umfasst;

(e) ausserhalb des ersten Emittergebietes (5) das erste Basisgebiet (6), und daran angrenzend zwischen den Einheitszellen (Z1,Z2) die Basisschicht (8) an die auf der Seite der ersten Hauptelektrode (H1) liegende Oberfläche des Halbleitersubstrats (1) treten; und

(f) in diesem Bereich über dem Halbleitersubstrat (1) auf der Seite der ersten Hauptelektrode (H1) eine isolierte erste Gateelektrode (4) angeordnet ist.

2. Bauelement nach Anspruch 1, dadurch gekennzeichnet, dass in der zweiten Einheitszelle (Z2) auf der dem Kontaktgebiet (7) gegenüberliegenden Seite die Emitterschicht (9) durch ein entgegengesetzt dotiertes Gebiet unterbrochen ist, welches mit der zweiten Hauptelektroden-Metallisierung (10) verbunden ist und zusammen mit der Basisschicht (9) und dem Kontaktgebiet (17) eine integrierte Inversdiode bildet.

3. Bauelement nach Anspruch 2, dadurch gekennzeichnet, dass das entgegengesetzt dotierte Gebiet, welches die Emitterschicht (9) unterbricht, ein separates Kurzschlussgebiet (21) ist.

4. Bauelement nach Anspruch 2, dadurch gekennzeichnet, dass das entgegengesetzt dotierte Gebiet, welches die Emitterschicht (9) unterbricht, Teil einer durchgehenden Stoppschicht (22) ist, welche zwischen der Emitterschicht (9) und der Basisschicht (8) angeordnet ist.

5. Bauelement nach Anspruch 1, dadurch gekennzeichnet, dass

(a) anstelle der durchgehenden Emitterschicht (9) lokalisierte zweite Emittergebiete (15) in den ersten Einheitszellen (Z1) vorgesehen sind;

(b) in den zweiten Einheitszellen (Z2) ein auf der Seite der zweiten Hauptelektrode (H2) in die Basisschicht (8) eingelassenes, zur Basisschicht (8) entgegengesetzt dotiertes zweites Basisgebiet (16) und ein in das zweite Basisgebiet (16) eingelassenes, zum zweiten Basisgebiet (16) entgegengesetzt dotiertes und mit der zweiten Hauptelektroden-Metallisierung (10) verbundenes drittes Emittergebiet (17) vorgesehen sind, welche zusammen mit der Basisschicht (8) und dem Kontaktgebiet (7) eine zur ersten Thyristorstruktur in den ersten Einheitszellen (Z1) antiparallele, zweite Thyristorstruktur bilden;

(c) das dritte Emittergebiet (17) randförmig ein gleichsinnig, aber schwächer dotiertes zweites Zentralgebiet (18) einschliesst;

(d) ausserhalb des dritten Emittergebietes (17) das zweite Basisgebiet (16), und daran angrenzend zwischen den Einheitszellen (Zl, Z2) die Basisschicht (8) an die auf der Seite der zweiten Hauptelektrode (H2) liegende Oberfläche des Halbleitersubstrats (1) treten; und

(e) in diesem Bereich auf der Seite der zweiten Hauptelektrode (H2) über dem Halbleitersubstrat (1) isolierte zweite Gateelektroden (19) angeordnet sind.

6. Bauelement nach einem der Ansprüche 1 bis 5, dadurch gekennzeichnet, dass die Basisschicht (8) n⁻-dotiert, die Emitterschicht (9) und das Kontaktgebiet (7) p⁺-dotiert, das erste Emittergebiet (5) n⁺-dotiert, das erste Zentralgebiet (11) n-dotiert und das erste Basisgebiet (6) p-dotiert ist.

7. Verfahren zur Herstellung eines Bauelements nach Anspruch 1, dadurch gekennzeichnet, dass zum Einbringen der randförmigen ersten Emittergebiete (5)

(a) bei dem Halbleitersubstrat (1), welches die Basisschicht (8), die ersten Basisgebiete (6), die ersten Zentralgebiete (11), die Kontaktgebiete (7) und die in einer ersten Gateisolierung (3) eingebetteten ersten Gateelektroden (3) enthält, in die erste Gate isolierung (3) im Bereich der ersten Zentralgebiete (11) jeweils eine Oeffnung (14) eingebracht wird;

(b) auf der Seite der ersten Hauptelektrode (H1) auf dem Halbleitersubstrat (1) ganzflächig eine stark dotierte Maskenschicht (12) abgeschieden wird;

(c) die Maskenschicht (12) anisotrop bis auf an den Rändern der Oeffnungen (14) stehenbleibende Maskenränder (13) abgetragen wird; und

(d) die Dotierung der ersten Emittergebiete (5) aus den Maskenrändern (13) vorgenommen wird.

8. Verfahren nach Anspruch 7, dadurch gekennzeichnet, dass als Maskenschicht (12) eine stark dotierte Schicht aus Polysilizium oder eine Schicht aus Phosphorsilikatglas verwendet wird.

# Fig.1

# Fig.2

Fig.3

Fig.4

Fig.5

Fig.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Band 13, Nr. 150 (E-742)[3498], 12. April 1989; & JP-A-63 310 171 (HITACHI LTD) 19-12-1988 * Zusammenfassung; Figuren 1,3 * | 1-3,6 | H 01 L 29/74 H 01 L 29/747 H 01 L 21/225 H 01 L 21/332 |
| A | EP-A-0 064 614 (K.K. TOSHIBA) * Seite 7, Zeile 9 - Seite 10, Zeile 28; Figuren 3-5 * | 1 | |
| A | DE-A-3 542 570 (SIEMENS AG) * Figuren 1,3 * | 3,4 | |
| A | DE-A-3 202 608 (TOKYO SHIBAURA DENKI K.K.) * Seite 14, Zeile 1 - Seite 15, Zeile 12; Figuren 3A-3C * | 7,8 | |

| | RECHERCHIERTE SACHGEBIETE (Int. Cl.5) |
|---|---|
| | H 01 L |

Der vorliegende Recherchenbericht wurde für alle Patentansprüche erstellt

| Recherchenort | Abschlußdatum der Recherche | Prüfer |
|---|---|---|
| Den Haag | 22 März 91 | MORVAN D.L.D. |